# EUROPÄISCHE PATENTANMELDUNG

(11) **EP 0 766 306 A1**
(43) Veröffentlichungstag der Anmeldung: **02.04.1997**
(21) Anmeldenummer: 96114617.2
(22) Anmeldetag: 11.09.1996
(51) Int. Cl.: H01L 21/84, H01L 27/12

(54) **Verfahren zur Herstellung einer Vielzahl von mikroelektronischen Schaltungen in SOI**

(30) Priorität: 28.09.1995 DE 19536262
(71) Anmelder: SIEMENS AKTIENGESELLSCHAFT, 80333 München (DE)
(72) Erfinder: Müller, Karlheinz, 84478 Waldkraiburg (DE)

(57) **Zusammenfassung**

Die Erfindung betrifft ein Verfahren zur Herstellung einer Vielzahl von mikroelektronischen Schaltungen auf SOI, bei dem durch einen standardisierten Prozeß auf besonders einfache Weise beispielsweise n-CMOS- oder p-CMOS-Transistoren, NPN-Transistoren oder PNP-Transistoren hergestellt werden können. Dazu ist lediglich eine Anpassung der durchgeführten Implantationen nötig.

## Beschreibung

Die Erfindung betrifft ein Verfahren zur Herstellung einer Vielzahl von mikroelektronischen Schaltungen auf SOI. Dabei werden insbesondere CMOS-Transistoren und/oder bipolare Transistoren hergestellt.

Bekannt sind eine Reihe verschiedener verfahren, mit denen mikroelektronische Schaltungen einschließlich CMOS-Transistoren oder bipolare Transistoren hergestellt werden können. Die Verfahren unterscheiden sich jedoch beträchtlich voneinander und lassen sich nicht oder nur mit großem Aufwand miteinander kombinieren.

Der Erfindung liegt die Aufgabe zugrunde, ein Verfahren zu schaffen, welches sich zur besonders einfachen Herstellung einer Vielzahl verschiedener mikroelektronischer Strukturen auf SOI und insbesondere von CMOS-Strukturen und bipolaren Transistoren eignet.

Die Lösung dieser Aufgabe erfolgt mit den Merkmalen des Anspruches 1. Vorteilhafte Weiterbildungen sind in den Unteransprüchen beschrieben.

Nach dem Grundgedanken der Erfindung wird in dem Isolatormaterial eine Vielzahl von aktiven Bereichen definiert, in den aktiven Bereichen jeweils in Abhängigkeit von der zu erzeugenden Struktur eine n-Wanne oder eine p-Wanne implantiert, Gateoxid erzeugt und in Teilbereichen der aktiven Bereiche definiert eine Polysiliziumschicht aufgebracht, in Abhängigkeit von der zu erzeugenden Struktur die Polisiliziumschicht n⁺ oder p⁺ dotiert und später die Dotierstoffe in die seitlichen Bereich der Wanne diffundiert, die Polysiliziumschicht zur Definition der aktiven Gebiete geätzt, eine Oxidation der Polysiliziumschicht und der vorher freigeätzten aktiven Gebiete durchgeführt, in Abhängigkeit von der zu erzeugenden Struktur eine p⁻ oder n⁻ Implantation zur Basisbildung oder LDD-Implantation durchgeführt wird, mit einer Temperaturbehandlung die implantierten Dotierstoffe in die darunterliegenden Wannenbereich diffundiert, eine Oxidschicht aufgebracht, und eine Kontaktierung durchgeführt.

Durch das erfindungsgemäße Verfahren besteht die besonders einfache Möglichkeit, auf einem Wafer eine Vielzahl von aktiven Bereichen zu definieren und unter Verwendung des gleichen Prozeßblocks eine Vielzahl von verschiedenen Strukturen herstellen zu können, wobei lediglich die durchgeführten Implantationen angepaßt werden müssen. Bei diesem besonders einfachen Verfahren wird lediglich eine Polysiliziumschicht verwendet.

Zur Herstellung einer n-CMOS-Struktur wird zunächst eine p-Wanne implantiert, eine n⁺ Source/Drain-Implantation und im abschließenden Implantationsschritt eine beidseitige n⁻ LDD-Implantation durchgeführt. Bei der Herstellung einer p-CMOS-Struktur muß hingegen zunächst eine n-Wanne implantiert werden und anschließend eine p⁺ Source/Drain-Implantation und abschließend eine beidseitige p⁻ LDD-Implantation durchgeführt werden.

In einer anderen bevorzugten Weiterbildung wird bei der Herstellung eines NPN-Transistors zunächst eine n-Wanne implantiert und dann eine n⁺ Implantation zur Herstellung der Emitter und Kollektorbereiche und später eine einseitige p⁻Implantation zur Erzeugung der Basis durchgeführt. Für die Herstellung eines PNP-Transistors wird zunächst eine p-Wanne sowie mit der anschließenden p⁻ Dotierung Emitter- und Kollektorbereiche erzeugt und anschließend mit einer n⁻ Implantation die Basis hergestellt.

Besonders günstig ist es, auf einem Wafer eine Vielzahl von gleichen Strukturen zu erzeugen. Auf diese Weise kann in einer Prozeßfolge eine Vielzahl von mikroelektronischen Bauelementen erzeugt werden. Ebensogut sind natürlich auch auf einem Wafer verschiedene Strukturen herstellbar. Dazu müssen innerhalb des erfindungsgemäß standardisierten Prozesses verschiedene Implantationen durchgeführt werden.

Durch das erfindungsgemäße Verfahren wird ein low cost BiCMOS-Prozeß auf SOI realisiert, bei dem lediglich eine Polysiliziumschicht für Gate, Source und Drain bei der Herstellung der CMOS-Transistoren oder für Emitter und Kollektor bei der Herstellung der bipolaren Transistoren verwendet wird.

Weiterhin ist es vorteilhaft, zur Herstellung der elektrischen Kontakte auf die zuletzt aufgebrachte Oxidschicht eine Borphosphorsilikatglas (BPSG)-Beschichtung aufzubringen und durch diese Schicht Kontaktlöcher bis zu den darunter liegenden Polysiliziumstrukturen zu ätzen. Durch diese Kontaktlöcher werden dann die metallischen Kontakte geführt.

Nach jedem Implantationsschritt kann ein Ausheilprozeß durchgeführt werden, um die Dotierstoffe zu aktivieren und für eine Diffusion der Dotierstoffe in die Bereiche des monokristallinen Siliziums der Wanne zu sorgen. Bevorzugt ist es, lediglich einen Ausheilschritt vorzunehmen, der nach der letzten Implantation erfolgt und gleichzeitig die Diffusion aller implantierten Dotierstoffe sicherstellt.

Nachfolgend wird die Erfindung anhand eines in der Zeichnung dargestellten Ausführungsbeispiels näher erläutert. Im einzelnen zeigen die schematischen Darstellungen in:
- Figuren 1 bis 5: verschiedene Verfahrensstände während des Prozeßablaufs;
- Figur 6: einen mit dem erfindungsgemäßen Verfahren erzeugten n-CMOS-Transistor;
- Figur 7: ein mit dem erfindungsgemäßen Verfahren erzeugten p-CMOS-Transistor;
- Figur 8: einen mit dem erfindungsgemäßen Verfahren hergestellten NPN-Transistor; und
- Figur 9: einen mit dem erfindungsgemäßen Verfahren hergestellten PNP-Transistor.

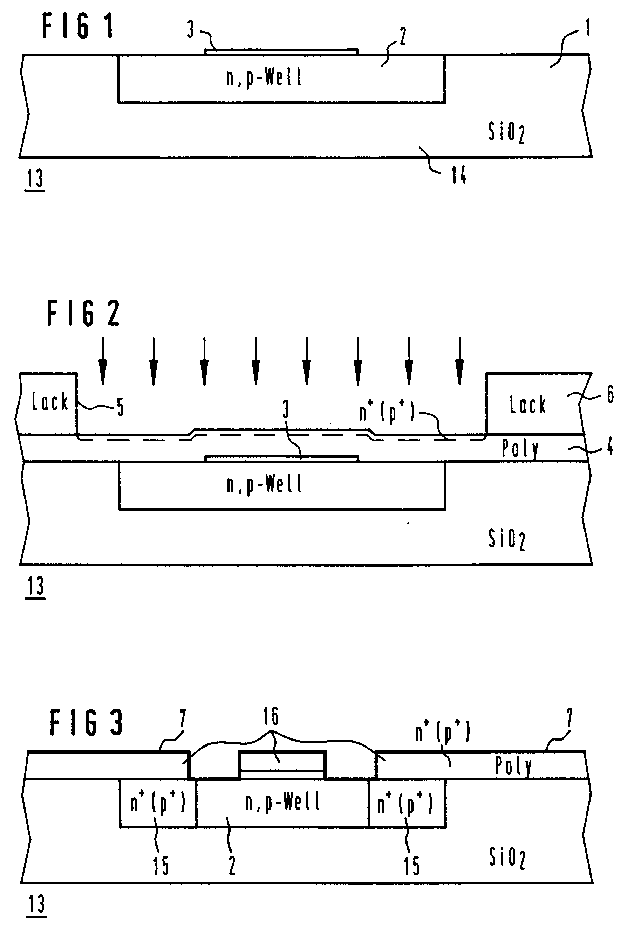

Zu Beginn des Verfahrens wird auf ein Substrat 13 eine Siliziumdioxidschicht (SiO₂) 14 und eine darüberliegende Siliziumschicht aufgebracht. Die aktiven Bereiche 1 werden durch MESA-Ätzung oder Oxidation in der Siliziumschicht definiert. Auf diese Weise entsteht der in der Figur 1 dargestellte aktive Bereich 1. Auf dem verwendeten Wafer werden eine Vielzahl von aktiven Bereichen 1 definiert, in denen jeweils eine der im folgenden beschriebenen Strukturen erzeugt wird. Zur einfacheren Darstellung ist in den Figuren immer nur ein aktiver Bereich 1 dargestellt. Mit einer Maskentechnik werden die Gebiete außerhalb der aktiven Bereiche 1 abgedeckt und in den aktiven Bereichen 1 durch eine I²-Implantation eine n-Wanne 2 oder eine p-Wanne 2 erzeugt. Diese werden auch als Well bezeichnet und bestehen aus Monosilizium. Dabei hängt die Auswahl der verwendeten Dotierung von der zu erzeugenden Struktur ab. So wird für einen n-CMOS-Transistor oder einen PNP-Transistor eine p-Wanne und für einen p-CMOS-Transistor oder einen NPN-Transistor eine n-Wanne erzeugt. Die so implantierte Wanne 2 wird durch Temperaturbehandlung ausgeheilt. Anschließend wird ein Gateoxid 3 aufgebracht und mit einer weiteren Maskentechnik strukturiert und SiO₂ geätzt, so daß das Gateoxid 3 nur einen Teilbereich der aktiven Bereiche 1 abdeckt.

In den nächsten, in Figur 2 dargestellten Schritten wird eine Polysiliziumschicht 4 ganzflächig aufgebracht. In dieser Polysiliziumschicht können durch n⁻ oder p⁻ Implantationen Hochohm-Widerstände erzeugt werden, die zur Verbindung und zum weiteren Anschluß der erzeugten Strukturen dienen. Weiterhin wird eine Lackmaske mit Bereichen 5 und 6 aufgebracht, mit der eine n⁺ oder eine p⁺ Implantation durchgeführt wird. Bei der Herstellung der CMOS-Transistoren dienen diese Implantationen zur Source/Drain-Implantation und bei der Herstellung von Transistoren zur Emitter- und Kollektorherstellung. Außerdem kann beispielsweise mit der n⁺ Implantation ein Basisanschluß für den PNP-Transistor oder Kapazitäten und Widerstände erzeugt werden. Umgekehrt kann mit der n⁻ Implantation ein Basisanschluß für den NPN-Transistor oder können auch Kapazitäten und Widerstände erzeugt werden.

In Figur 3 sind n⁺ oder p⁺ dotierte äußere Bereiche 15 in der Wanne 2 dargestellt. Diese entstehen durch einen mit einer Temperaturbehandlung vorgenommenen Ausheilprozeß, bei dem die in der Polisiliziumschicht 4 implantierten Dotierstoffe in die darunterliegenden Bereiche der Wanne 2 diffundieren. Das Gateoxid 3 wirkt als Diffusionsstop im zentralen Bereich der Wanne 2, so daß dort keine Dotierstoffe hin diffundieren können. Weiterhin werden durch eine Ätzung der Polysiliziumschicht 4 aktive Gebiete 16 erzeugt. Die Ätzung entfernt auch das in diesem Bereich vorhandene Gateoxid 3 und führt bis zur darunter liegenden Wanne 2. Anschließend wird eine Oxidation durchgeführt, bei der eine Oxidschicht 7 sowohl im Bereich der Polysiliziumschicht 4 als auch an den vorher freigeätzten Seitenwänden der aktiven Gebiete 16 und der vorher freigeätzten Wannenbereiche entsteht.

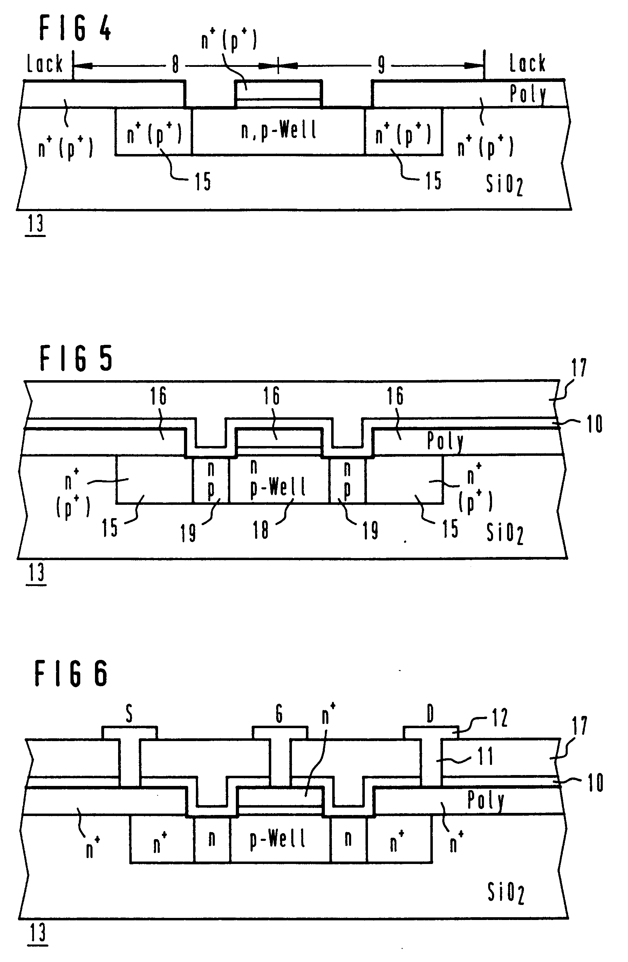

Die nächsten Schritte sind in Figur 4 dargestellt. So wird eine Lackmaske 8, 9 aufgebracht, mit deren Hilfe eine p⁻ oder n⁻ I²-Implantation durchgeführt wird, so daß nach einem Ausheilprozeß in der Wanne zusätzliche, in Figur 5 dargestellte Strukturen entstehen. Die erhöhte Temperatur beim Ausheilprozeß führt zu einer Diffusion der Dotierstoffe aus dem Polysilizium in die Monosiliziumbereiche der Wanne 2. Die so erzeugten zusätzlichen Strukturen liegen in einem Zwischenbereich 19 der Wanne zwischen dem zentralen Bereich 18 der Wanne und den vorher erzeugten n⁺ bzw. p⁺ dotierten äußeren Bereichen 15. Mit der p⁻ I²-Implantation läßt sich im NPN-Transistor die Basis erzeugen oder in dem p-CMOS-Transistor eine LDD-Implantation durchführen. Analog würde mit der n⁻I²-Implantation die Basis des PNP-Transistors erzeugt oder in dem n-CMOS-Transistor eine LDD-Implantation durchgeführt.

Wie bereits vorher beschrieben, sind in Figur 5 die im vorangegangenen Ausheilprozeß erzeugten Bereiche 19 dargestellt. Auf die bis hierhin erzeugte Struktur wird eine Oxidschicht 10 aufgebracht, die in ihrem Verlauf der bisher erzeugten Struktur in den aktiven Gebieten 16 folgt. Darauf wird eine relativ dicke Borphosphorsilikatglas-Schicht 17 aufgebracht, die zum weiteren Schutz der darunter liegenden Schaltung dient.

Beispielsweise ist in Figur 6 dargestellt, wie durch die PBSG-Schicht 17 Kontaktlöcher 11 ausgebildet sein können, die bis zu den aktiven Gebieten der Polysiliziumschicht 4 ausgebildet sind. Durch die geätzten Kontaktlöcher 11 werden metallische Kontakte 12 zum Anschluß an die Schaltung gelegt.

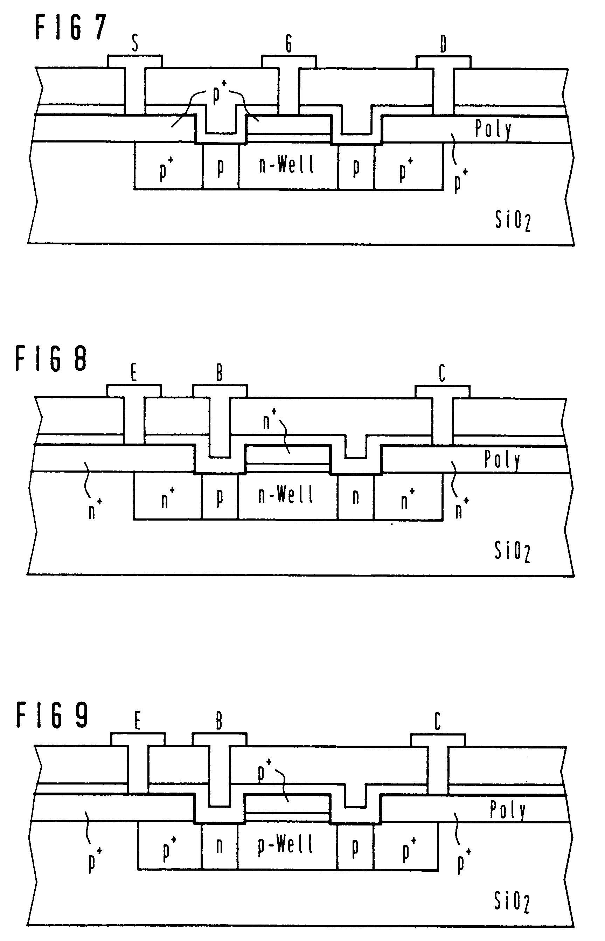

Mit diesem Verfahren hergestellbare Strukturen sind in den Figuren 6 bis 9 dargestellt. Dabei ist in Figur 6 eine n-CMOS-Struktur, in Figur 7 eine p-CMOS-Struktur, in Figur 8 ein NPN-Transistor und in Figur 9 ein PNP-Transistor dargestellt. In den Figuren steht S für Source, D für Drain und G für Gate. Die Bezeichnungen E, B und C bei den Transistoren stehen für Emitter, Basis und Kollektor.

## Patentansprüche

1. Verfahren zur Herstellung einer Vielzahl von mikroelektronischen Schaltungen auf SOI, insbesondere von CMOS-Transistoren und/oder bipolaren Transistoren, bei dem
in dem Isolatormaterial eine Vielzahl von aktiven Bereichen (1) definiert werden,
in den aktiven Bereichen (1) jeweils in Abhängigkeit von der zu erzeugenden Struktur eine n-Wanne oder eine p-Wanne (2) implantiert wird,
Gateoxid (3) erzeugt und in Teilbereichen des aktiven Bereichs (1) definiert wird,
eine Polysiliziumschicht (4) aufgebracht wird,
ein über der Wanne (2) liegender Bereich der Polysiliziumschicht (4) in Abhängigkeit von der zu erzeugenden Struktur n⁺ oder p⁺ dotiert wird,
die Polysiliziumschicht (4) zur Definition der aktiven Gebiete (16) geätzt wird,
eine Oxidation unter Bildung einer Oxidschicht (7) der Polysiliziumschicht (4) und der vorher freigeätzten aktiven Gebiete (16) durchgeführt wird,
in Abhängigkeit von der zu erzeugenden Struktur eine p⁻ oder n⁻ Implantation durchgeführt wird,
mit einer Temperaturbehandlung die implantierten Dotierstoffe in die darunterliegenden Wannenbereiche (18, 19) diffundiert werden,
eine Oxidschicht (10) aufgebracht wird, und eine Kontaktierung durchgeführt wird.

2. Verfahren nach Anspruch 1,
dadurch **gekennzeichnet,**
daß zur Herstellung einer n-CMOS-Struktur zunächst eine p-Wanne implantiert wird, eine n+ Source/Drain-Implantation und anschließend eine beidseitige n⁻ LCD-Implantation durchgeführt wird.

3. Verfahren nach Anspruch 1,
dadurch **gekennzeichnet**,
daß zur Herstellung einer p-CMOS-Struktur zunächst eine n-Wanne (2) implantiert wird, eine p+ Source/Drain-Implantation und anschließend eine beidseitige p⁻ LDD-Implantation durchge-führt wird.

4. Verfahren nach Anspruch 1,
dadurch **gekennzeichnet**,
daß zur Herstellung eines NPN-Transistors zunächst eine n-Wanne (2) implantiert wird, eine n+ Implantation zur Herstellung der Emitter- und Kollektorbereiche und dann eine einseitige p⁻ Implantation zur Erzeugung der Basis durchgeführt wird.

5. Verfahren nach Anspruch 1,
dadurch **gekennzeichnet**,
daß zur Herstellung eines PNP-Transistors zunächst eine p-Wanne (2) dotiert wird, eine p⁺ Implantation zur Herstellung der Emitter- und Kollektorbereiche und anschließend eine einseitige n⁻ Dotierung zur Basiserzeugung durchgeführt wird.

6. Verfahren nach einem der vorhergehenden Ansprüche,
dadurch **gekennzeichnet**,
daß eine Vielzahl von gleichen Strukturen erzeugt wird.

7. Verfahren nach einem der vorhergehenden Ansprüche,
dadurch **gekennzeichnet**,
daß nur eine Polysiliziumschicht (4) zur Erzeugung der Strukturen verwendet wird.

8. Verfahren nach einem der vorhergehenden Ansprüche,
dadurch **gekennzeichnet**,
daß zur Kontaktierung auf der Oxidschicht (10) eine BPSG-Beschichtung (17) durchgeführt wird, Kontaktlöcher (11) geätzt werden und metallische Kontakte (12), die durch die Kontaktlöcher auf die Polysiliziumschicht (4) geführt werden, hergestellt werden.

9. Verfahren nach einem der vorhergehenden Ansprüche,
dadurch **gekennzeichnet**,
daß nur ein Ausheilprozeß nach Durchführung der letzten Implantation durchgeführt wird.
